# EUROPÄISCHE PATENTANMELDUNG

(11) **EP 0 699 987 A2**
(43) Veröffentlichungstag der Anmeldung: **06.03.1996**
(21) Anmeldenummer: 95112183.9
(22) Anmeldetag: 03.08.1995
(51) Int. Cl.: G05F 1/573

(54) **Überstrombegrenzungseinrichtung**

(30) Priorität: 01.09.1994 DE 4431077
(71) Anmelder: ANT Nachrichtentechnik GmbH, D-71522 Backnang (DE)
(72) Erfinder: Nathan, Adolf, D-71522 Backnang (DE)

(57) **Zusammenfassung**

Bei Überstrom wird ein elektronischer Schalter (S) im Burstbetrieb gesteuert.

Die Anzahl der Burstimpulse sowie deren Einschalt- zu Pausenzeit ist so gewählt, daß die durch den Überstrom bedingte Aufheizung des Schalters (S) gegenüber der durch die thermische Zeitkonstante bestimmte Aufheizung zeitlich gedehnt wird.

Durch diese Maßnahme wird eine störsichere Strombegrenzung hoher Verfügbarkeit erreicht.

## Beschreibung

Die Erfindung betrifft eine Überstrombegrenzungseinrichtung mit einem elektronischen Schalter, welcher im Burstbetrieb steuerbar ist.

Überstrombegrenzungseinrichtungen, insbesondere für Längsregler, weisen Stromüberwachungsschaltungen auf, die das Stellglied nach Überschreiten eines vorgewählten Strom-Grenzwertes entweder abschalten (DE 39 32 399 C1) oder den Strom durch das Stellglied reduzieren (DE 34 05 847 C1).

Bei der Ausbildung gemäß DE 39 32 399 C1 wird das Abschalten des Stellgliedes verzögert vorgenommen; d.h. ein vollständiges Abschalten erfolgt erst dann, wenn während einer vorgewählten Verzögerungszeit der Strom nicht auf einen unter einem Grenzwert liegenden Wert zurückgeht.

Aus der DE 42 23 339 C1 ist eine Überlastungsschutzschaltung für ein Reglerstellglied bekannt. Dort wird das Stellglied bei Erreichen einer vorgegebenen Verlustenergie abgeschaltet. Damit die Abschaltung des Stellgliedes in Abhängigkeit der tatsächlich aufgenommenen Verlustleistung erfolgt, ist dem den Abschaltzeitpunkt bestimmenden Komparator ein Integrator vorgeschaltet, welcher bezüglich seiner Zeitkonstante auf die thermische Zeitkonstante des Stellgliedes abgestimmt ist.

Aufgabe vorliegender Erfindung ist es, die Überstrombegrenzungseinrichtung so auszugestalten, daß eine störsichere, wenig aufwendige Überstrombegrenzung möglich ist. Diese Aufgabe wird durch die Merkmale des Anspruchs 1 gelöst. In den weiteren Ansprüchen sind vorteilhafte Ausgestaltungen aufgezeigt.

Im Gegensatz zu herkömmlichen Lösungen arbeitet die Einrichtung gemäß der Erfindung während des Aufheizens des Stellgliedes bei Überstrom stets im Burstbetrieb mit definierter Vorgabe der Burstimpulse bezüglich Einschalt- und Pausenzeit. Zufällige Störungen können so das Strombegrenzungsverhalten nicht nachteilig beeinflussen. Im Gegensatz zu herkömmlichen Reglern, seien sie als Verlustregler oder als Schaltregler ausgebildet, treten keine instabilen Zustände (Regelschwingungen) auf. Es muß lediglich die Tatsache des Überstromfalles bekannt sein, was mit einem einfachen Überstromdetektor feststellbar ist, um den definierten Burstbetrieb in Abhängigkeit der bekannten thermischen Zeitkonstanten für den Aufheiz- und den Abkühlvorgang einzuleiten. Es müssen keine zusätzlichen Parameter, wie etwa die Stellglied-Temperatur oder Lastsprungänderungen, erfaßt werden. Durch die definierte Vorgabe der Burstimpulse bezüglich Einschalt- zu Pausenzeit kann der Aufwand von Kühlmaßnahmen für das Stellglied begrenzt werden. Für die Bemessung der Burstimpulse müssen lediglich die thermischen Zeitkonstanten bekannt sein, bzw. durch eine einmalige einfache Messung ermittelt werden. Die Einrichtung nach der Erfindung ist nicht nur gegen externe Störungen resistent, sondern auch gegen eigene Störungen. Drifterscheinungen von Schwellwertkomparatoren, wie sie bei herkömmlichen Reglern auftreten und zu Fehlern im Regelverhalten führen, spielen keine Rolle. Die Erfindung eignet sich insbesondere als Steckschutz für nachrichtentechnische Geräte.

Durch den Burstbetrieb des elektronischen Schalters ist die Betriebsbereitschaft bzw. die Verfügbarkeit hoch, insbesondere wenn der Überstrom während des Burstbetriebs wieder abklingt.

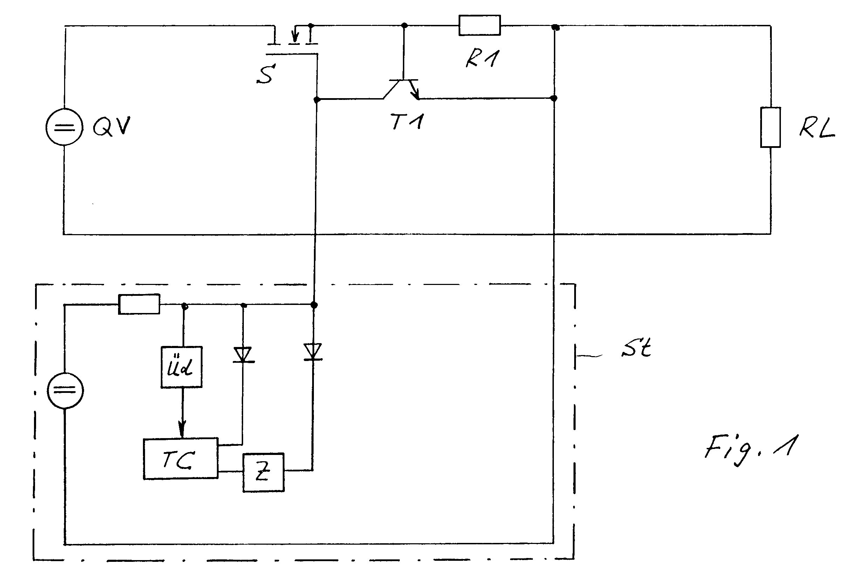

Anhand der Zeichnungen werden Ausführungsbeispiele der Erfindung nun näher erläutert. Es zeigen
Fig. 1 ein Prinzipschaltbild einer Einrichtung nach der Erfindung,
Fig. 2 den zeitlichen Verlauf der Aufheizung und Abkühlung des elektronischen Schalters bei Überstrom,
Fig. 3 den Burstbetrieb des elektronischen Schalters.

Die Überstrombegrenzungseinrichtung nach der Erfindung besteht aus einem elektronischen Schalter S, beispielsweise in Form eines Feldeffekttransistors zwischen einer Gleichspannungsversorgungsquelle QV und einer Last RL. Die Last RL kann z.B. ein Stromversorgungsgerät sein. In Serie zur Drain-Source-Strecke dieses Feldeffekttransistors liegt ein Widerstand R1, über dessen Spannungsabfall die Emitter-Basisstrecke des Transistors T1 steuerbar ist. Der Kollektor des Transistors T1 führt zum Gate des Feldeffekttransistors. Die Anordnung, bestehend aus Feldeffekttransistor S, Transistor T1 und Widerstand R1, wirkt als Stromquelle, deren Strom über das Gate des Feldeffekttransistors S steuerbar ist. Im Überstromfall, z.B. bei einem Kurzschluß bei der Last RL, wird der elektronische Schalter S, bzw. die Stromquelle, über eine Steuerschaltung St mit Burstimpulsen betrieben. Zur Erzeugung dieser Burstimpulse enthält die $teuerschaltung eine Zeitgeberschaltung TC, für die der Timer-IC NE 555 mit üblicher RC-Beschaltung verwendet werden kann. Die Aktivierung der Zeitgeberschaltung TC kann über einen herkömmlichen Überstromdetektor Üd erfolgen, der an die Steuerleitung des elektronischen Schalters S angeschlossen ist. Der Zeitgeberschaltung TC ist außerdem ein Zähler Z zugeordnet, der die Burstimpulse zählt und nach einer vorgegebenen Anzahl von Burstimpulsen eine vorgegebene Pausenzeit einleitet; d.h. die Ansteuerung des elektronischen Schalters S für diese Pausenzeit unterbindet.

Für den Burstbetrieb werden folgende Bedingungen eingehalten:
- das Verhältnis von Einschalt- zu Pausenzeit der Burstimpulse ist kleiner 1,
- die Anzahl der Burstimpulse pro Burst sowie deren Einschalt- zu Pausenzeit ist so gewählt, daß die Aufheizzeit des elektronischen Schalters S gegenüber der durch seine thermische Zeitkonstante vorgegebenen Aufheizzeit um einen vorgegebenen Wert größer 1, z.B. um den Faktor 10, gedehnt ist,
- der zeitliche Abstand aufeinanderfolgender Bursts ist größer oder zumindest gleich der durch die thermische Zeitkonstante des elektronischen Schalters S gegebenenfalls unter Einbeziehung von Kühlelementen vorgegebenen Abkühlzeit.

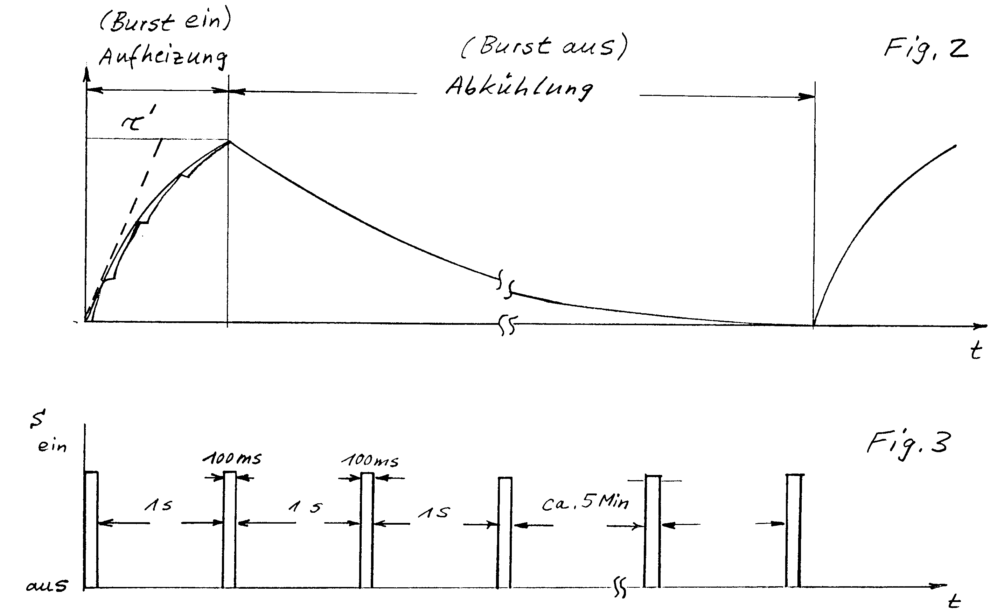

Der gewählte Dehnfaktor wird von der geforderten Störsicherheit vorgegeben. Wie aus der Figur 2 hervorgeht, ist die thermische Zeitkonstante τ' des elektronischen Schalters S für die Aufheizzeit bei Überstrom durch die Anfangssteigung der exponentiellen Aufheizkennlinie gegeben. Durch obige Bemessung der Burstimpulse wird die Aufheizzeit, z.B. um den Faktor 10, zeitlich gedehnt. Würde der elektronische Schalter S bei dauernder Ansteuerung innerhalb von 400 msec seine maximal zulässige Junction-Temperatur von 100° C erreichen, so wird dieser Zeitraum durch den Burstbetrieb auf ca. 4,0 sec gedehnt.

Figur 3 zeigt einen beispielhaften Burstverlauf hierzu im Detail. Der Burst besteht beispielsweise aus vier Burstimpulsen von jeweils 100 msec Einschaltzeit und 1 sec Pausenzeit. Natürlich kann die Anzahl der Burstimpulse pro Burst auch anders gewählt werden, wenn zusammen mit den entsprechenden Einschalt- und Pausenzeiten obige Bedingung eingehalten wird. Bei dem vorgestellten Beispiel ist die thermische Zeitkonstante für den Abkühlvorgang derart, daß die Abkühlzeit im Bereich zwischen 2 und 10 Minuten, beispielsweise bei 5 Minuten liegt. Nach obiger Bedingung bestimmt sich dadurch der zeitliche Abstand aufeinanderfolgender Bursts zu mindestens 5 Minuten.

Durch die zeitliche Dehnung der Aufheizzeit kann der Überstromfall während dieser Zeit bereits abgeklungen sein. Da der Überstromdetektor Üd dann nicht mehr anspricht, kann ein unmittelbarer Übergang vom Burstbetrieb in den regulären Betrieb - der Feldeffekttransistor S ist voll durchgeschaltet, bzw. die Stromquelle liefert ihren Nennstrom - erfolgen. Die Verfügbarkeit im regulären Betrieb ist damit sehr hoch. Die maximal zulässige Junction-Temperatur des elektronischen Schalters hat sich dann noch nicht eingestellt; d.h. es muß auch kein Abkühlungsvorgang abgewartet werden.

## Patentansprüche

1. Überstrombegrenzungseinrichtung mit einem elektronischen Schalter (S), welcher im Burstbetrieb steuerbar ist, wobei für den Burstbetrieb folgende Bedingungen eingehalten sind:
- das Verhältnis von Einschalt- zu Pausenzeit der Burstimpulse ist kleiner 1,
- die Anzahl der Burstimpulse pro Burst sowie deren Einschalt- zu Pausenzeit ist so gewählt, daß die Aufheizzeit des elektronischen Schalters (S) gegenüber der durch seine thermische Zeitkonstante vorgegebenen Aufheizzeit um einen vorgegebenen Faktor, der größer als 1 ist, gedehnt ist,
- der zeitliche Abstand aufeinanderfolgender Bursts ist größer oder zumindest gleich der durch die thermische Zeitkonstante des elektronischen Schalters (S), gegebenenfalls unter Einbeziehung von Kühlelementen, vorgegebenen Abkühlzeit.

2. Einrichtung nach Anspruch 1, dadurch gekennzeichnet, daß dem elektronischen Schalter (S) eine Steuerschaltung (St) zugeordnet ist, die eine Zeitgeberschaltung (TC) zur Generierung der Burstimpulse in Abhängigkeit eines Überstromdetektors (Üd) aufweist.

3. Einrichtung nach Anspruch 1 oder 2, dadurch gekennzeichnet, daß jeder Burst vier Burstimpulse mit jeweils einer Einschaltzeit von etwa 100 msec aufweist und daß der zeitliche Abstand zwischen den Bursts im Bereich von 2 bis 10 Minuten gewählt ist.

4. Einrichtung nach Anspruch 1, 2 oder 3, dadurch gekennzeichnet, daß ein Impulszähler (Z) zur Vorgabe der Aufheiz- und Abkühlzeit vorgesehen ist.
